# EUROPEAN PATENT APPLICATION

(11) **EP 2 280 413 A2**
(43) Date of publication of application: **02.02.2011**
(21) Application number: 09738919.1
(22) Date of filing: 26.03.2009
(51) Int. Cl.: H01L 23/495

(54) **METAL FRAME FOR ELECTRONIC COMPONENTS**

(30) Priority: 29.04.2008 KR 20080039904
(71) Applicant: Iljin Copper Foil Co., Ltd., Iksan-si Jeollabuk-do 570-998 (KR)
(72) Inventor: LEE, Dong Nyung, Seoul 156-030 (KR); KIM, Sang Beom, Daejeon 305-150 (KR); KANG, Kyoo Sik, Seoul 135-989 (KR); IM, Su Chul, Ulsan 682-030 (KR)
(74) Representative: Kling, Simone
(86) International application number: PCT/KR2009/001551
(87) International publication number: WO 2009/134012

(57) **Abstract**

Provided is a metal frame for an electronic part and capable of minimizing defects such as an electric short circuit caused by whiskers. The metal frame may include a lead unit electrically connected to an electronic device, and the lead unit may include a first metal layer that contains copper (Cu) as a main component and further contains boron (B) or beryllium (Be).

## Description

### CROSS-REFERENCE TO RELATED PATENT APPLICATION

This application claims the benefit of Korean Patent Application No. 10-2008-0039904, filed on April 29, 2008, in the Korean Intellectual Property Office, the disclosure of which is incorporated herein in its entirety by reference.

### BACKGROUND OF THE INVENTION

### 1. Field of the Invention

The present invention relates to a metal frame for an electronic part, and more particularly, to a metal frame for an electronic part and capable of minimizing defects caused by whiskers.

### 2. Description of the Related Art

Electronic parts to be used in various electric and electronic devices include an electronic element such as a semiconductor device or an electronic light-emitting device, and a metal frame that electrically connects the electronic element to an external circuit device and supports to maintain the shape of the electronic element. A representative metal frame for an electronic part is a lead frame used in a semiconductor package.

A metal frame for an electronic part is electrically connected to an electronic element mounted on the metal frame and is also electrically connected to an external circuit device. In most cases, electrical connection with the external circuit device may be achieved by soldering.

Soldering is a technology of bonding a target material to be bonded, by using solder having a melting point equal to or lower than 450 °C and by melting only the solder without melting a base metal.

Recently, as international control over lead (Pb) is tightened, a Pb-free tin (Sn)-based solder alloy that contains Sn as a main component has been popularly used for the soldering. The main representative examples of a Pb-free solder alloy are Sn-silver (Ag)-based, Sn-copper (Cu)-based, Sn-bismuth (Bi)-based, Sn-zinc (Zn)-based alloys which contain Sn as a main component and to which Ag, Cu, Zn, indium (In), nickel (Ni), chromium (Cr), iron (Fe), cobalt (Co), germanium (Ge), phosphorus (P), and gallium (Ga) are appropriately added.

Meanwhile, the metal frame is assembled with the electronic device so as to form an electronic part, a Cu-based alloy having excellent electric conductivity and Pb solderability is commonly used, and surface plating is performed by using a Sn-based alloy.

However, if the metal frame is used for a long time, whiskers may easily form between the metal frame and a solder alloy or on a surface of the metal frame. The whiskers are protruding crystals formed on surfaces of different materials when the materials are bonded to each other and mutual diffusion occurs therebetween, and are sensitive to heat and moisture. If the whiskers are formed on a surface of the metal frame, an electric short circuit occurs in a circuit and thus a life span of an electronic part is reduced.

### SUMMARY OF THE INVENTION

The present invention provides a metal frame for an electronic part and capable of minimizing defects such as an electric short circuit caused by whiskers.

According to an aspect of the present invention, there is provided a metal frame for an electronic part, the metal frame including a lead unit electrically connected to an electronic device, wherein the lead unit includes a first metal layer that includes copper (Cu) as a main component and further includes boron (B) or beryllium (Be).

B or Be may be from about 0.01 weight% to about 0.5 weight%, and Cu and inevitable impurities may be the remaining weight%.

The first metal layer may further include iron (Fe) and Fe may be from about 0.1 weight% to about 6 weight%.

The first metal layer may further include phosphorus (P) and P may be from about 0.006 weight% to about 0.2 weight%.

The first metal layer may be integrally formed with at least the lead unit.

The metal frame may further include a mounting unit on which the electronic device is mounted, and the mounting unit and the lead unit may be formed of the same material.

The metal frame may further include a second metal layer that includes Sn as a main component, on a surface of the lead unit, to be electrically connected to at least the electronic device. In this case, the second metal layer may be a plating layer formed of pure Sn.

According to the present invention, a metal frame for an electronic part and capable of suppressing formation of whiskers may be provided.

The whiskers may also be prevented from forming by forming a tin (Sn)-based metal layer or even a pure Sn plating layer on at least one surface of the metal frame. Accordingly, a cheap and high-quality metal frame for an electronic part may be provided.

### BRIEF DESCRIPTION OF THE DRAWINGS

The above and other features and advantages of the present invention will become more apparent by describing in detail exemplary embodiments thereof with reference to the attached drawings in which:
FIG. 1 is a plan view of a lead frame for a semiconductor package as an example of a metal frame for an electronic part, according to an embodiment of the present invention;
FIG. 2 is a cross-sectional view of a semiconductor package in which a molding process is performed on the lead frame illustrated in FIG. 1; and
FIG. 3 is a magnified cross-sectional view of another example of a portion A illustrated in FIG. 2.

### DETAILED DESCRIPTION OF THE INVENTION

Hereinafter, the present invention will be described in detail by explaining embodiments of the invention with reference to the attached drawings. The invention may, however, be embodied in many different forms and should not be construed as being limited to the embodiments set forth herein; rather, these embodiments are provided so that this disclosure will be thorough and complete, and will fully convey the concept of the invention to one of ordinary skill in the art.

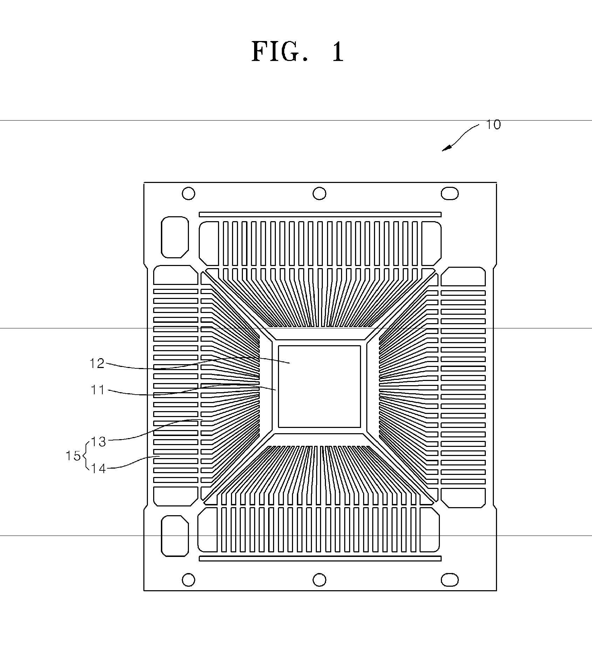

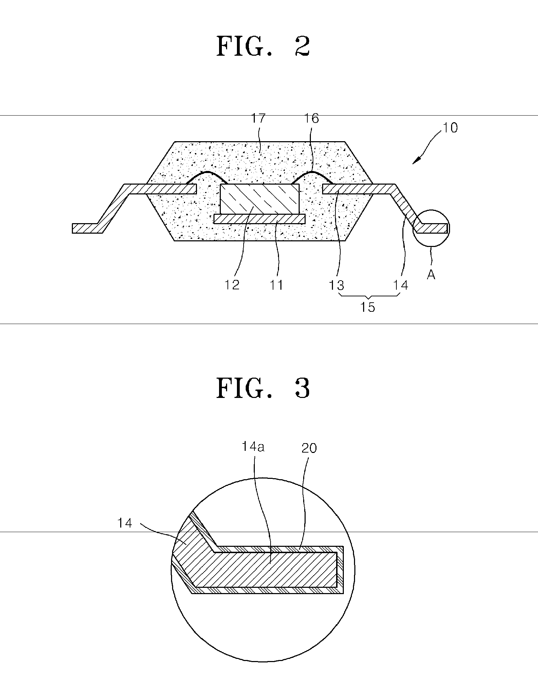

FIG. 1 is a plan view of a lead frame 10 for a semiconductor package as an example of a metal frame for an electronic part, according to an embodiment of the present invention. FIG. 2 is a cross-sectional view of a semiconductor package in which a molding process is performed on the lead frame 10 illustrated in FIG. 1.

Referring to FIG. 1, the lead frame 10 includes a die pad 11 that functions as a mounting unit on which another component, e.g., a memory device such as a semiconductor chip 12, is mounted, and a lead unit 15 that electrically connects the semiconductor chip 12 to an external circuit. The lead unit 15 according to the current embodiment may include internal leads 13 connected to the semiconductor chip 12 by performing wire bonding, and external leads 14 used to connect the semiconductor chip 12 to the external circuit.

As illustrated in FIG. 2, the semiconductor chip 12 is mounted on the die pad 11, the semiconductor chip 12 is bonded to the internal leads 13 by wires 16, and then the lead frame 10 is molded with a resin protector 17 to be supported by the resin protector 17.

In the above-described structure of the lead frame 10, at least the lead unit 15, more particularly, the external leads 14 may be formed of an alloy that contains copper (Cu) as a main component. Also, at least the lead unit 15, more particularly, the external leads 14 may include a first metal layer that contains Cu as a main component and further contains boron (B) or beryllium (Be). Here, the alloy that contains Cu as a main component means a Cu-based poly-alloy of which a main element is Cu and, in this case, Cu may be contained in at least 80 weight%. The lead unit 15 may have sufficient conductivity and strength to function as a lead unit, by containing Cu as a main component.

According to the current embodiment, the first metal layer may be located on a portion in which at least the lead unit 15 of the lead frame 10 is bonded to at least a solder material, and may be formed integrally with at least the lead unit 15. The entire lead unit 15 may be a single first metal layer.

In the lead frame 10, the lead unit 15, more particularly, the external leads 14, even more particularly, the first metal layer may be electrically connected to the external circuit by the solder material that contains tin (Sn) as a main component.
In this case, as described above in the description of the related art, whiskers may form due to mutual diffusion between the Cu component of the lead unit 15 and the Sn component of the solder material.

In order to suppress formation of the whiskers, the present inventors add Be or B as a second element to the first metal layer of the lead unit 15, which contains Cu as a main component.

A metal frame for an electronic part, e.g., a lead frame for a semiconductor package, is bonded to an external circuit through a solder material that mainly contains Sn. In this case, whiskers may form on a surface of the solder material due to reaction between the metal frame and the solder material and the cause of the whiskers has not been clarified yet.

The present inventors paid attention to a fact that, if a metal frame that contains Cu as a main component is bonded to a solder material that contains Sn as a main component, mutual diffusion occurs between the metal frame and the solder material.

In more detail, when mutual diffusion occurs between the Cu component of the metal frame and the Sn component of the solder material, the diffusion speed of the Cu component from the metal frame to the solder material is greater than that of the Sn component from the solder material to the metal frame. In particular, the diffusion speed of the Cu component along grain boundaries of the solder material is great. Then, an intermetallic compound CuxSny is formed on a bonding interface between the metal frame and the solder material.

The present inventors regard that compressive stress is caused in the solder material due to the mutual diffusion and that hair-shaped single crystals, i.e., the whiskers form on the surface of the solder material in order to decrease the compressive stress.

Accordingly, the present inventors suggest a method of suppressing formation of the whiskers by suppressing intermetallic diffusion between Cu and Sn by penetrating a metal having a small atom size into interstitial sites of Sn crystals of the solder material, in order to suppress the mutual diffusion between the metal frame and the solder material, and thus decreasing the compressive stress of the solder material. In more detail, the metal having a small atom size, which is contained in the first metal layer of the metal frame, is penetrated into the interstitial sites of the Sn crystals before being penetrated into Cu when the mutual diffusion occurs between Cu and Sn. As such, the intermetallic diffusion between Cu and Sn is suppressed.

### Be or B is used as the metal having a small atom size.

Thus, the first metal layer may contain Be or B as a second element, in addition to an alloy that mainly contains Cu, and the first metal layer may acceptably contain only Cu and Be, or Cu and B.

Be or B contained in the Cu-based alloy may be from about 0.005 weight% to about 0.5 weight%.

In comparison to a case when the second element, i.e., Be or B, is less than 0.005 weight%, about 0.005 weight% to about 0.5 weight% of Be or B is sufficient to suppress formation of the whiskers by being diffused into the solder material to the interstitial sites of the Sn crystals. Thus, the whiskers may not form even under severe conditions such as a thermal shock test and a constant temperature and humidity test to be described later. Meanwhile, if the second element, i.e., Be or B, is greater than 0.005 weight%, Be or B penetrated into interstitial sites of Cu is saturated, thereby increasing costs and reducing economical efficiency.

In the lead frame 10 according to the current embodiment, the die pad 11 and the lead unit 15 may be formed of the same material. In more detail, the die pad 11 and the lead unit 15 may be press-formed by using the same plate.

The first metal layer may further contain iron (Fe) so as to improve rigidity.

Fe may be from about 0.1 weight% to about 6 weight%.

Due to Fe, precipitation strengthening may be enhanced and thus the strength of the alloy may be improved.

Also, the lead frame 10 may further contain phosphorus (P).

P may be from about 0.006 weight% to about 0.2 weight%.

P may improve the strength of the alloy.

In addition, the first metal layer may further contain small amounts of nickel (Ni), Sn, indium (In), magnesium (Mg), manganese (Mn), silicon (Si), titanium (Ti), chromium (Cr), etc., in order to improve the strength of the alloy, and may further contain zinc (Zn) in order to improve oxide film adhesion, heat resistance, and separation resistance with respect to the solder material.

Meanwhile, according to another embodiment of the present invention, as illustrated in FIG. 3, at least the lead unit 15, more particularly, the external leads 14 may further include a second metal layer 20 to prevent the lead frame 10 from being corroded and to improve junction with the solder material. In order to improve junction with the solder material, the second metal layer 20 contains Sn as a main component.

As described above, the second metal layer 20 that contains Sn as a main component may also prevent formation of the whiskers on a surface of the second metal layer 20 or the solder material due to reaction between the lead frame 10 and the second metal layer 20.

In more detail, as Be or B contained in the lead frame 10 is diffused into interstitial sites of Sn crystals, diffusion between Cu and Sn is suppressed and thus formation of the whiskers is suppressed.

Accordingly, formation of the whiskers may be suppressed on the lead frame 10 on which the second metal layer 20 is formed even after a long time.

Meanwhile, according to the current embodiment, the second metal layer 20 may be a plating layer formed of pure Sn.

In a general lead frame, although plating with a Sn-based metal is common in order to improve junction with a Sn-based solder material, plating with pure Sn increases the formation of whiskers and thus is not appropriate.

However, according to the current embodiment, since the lead frame 10 is formed of a metallic material in which Be or B is contained in a Cu component, although the plating layer formed of pure Sn is formed on the lead frame 10, diffusion between the plating layer and a base metal of the lead frame 10 may be suppressed as described above and thus formation of the whiskers may be prevented.

Pure Sn is cheaper than alloy Sn and has excellent junction with a solder material. A plating layer formed of pure Sn may be formed on the lead frame 10 according to the current embodiment.

Thus, the lead frame 10 having excellent characteristics may be provided without whiskers at a low price.

Meanwhile, as illustrated in FIG. 3, the second metal layer 20 may be formed on the whole surface of the lead unit 15, more particularly, on the entire surfaces of the external leads 14. In order to prevent the whole lead frame 10 from being corroded, the second metal layer 20 may be formed on the whole surface of the lead frame 10 including the die pad 11.

However, if additional processing is performed, it is also acceptable that the second metal layer 20 is formed on a surface of a bonding portion 14a between the external leads 14 and the solder material.

While the present invention has been particularly shown and described with reference to exemplary embodiments thereof, it will be understood by one of ordinary skill in the art that various changes in form and details may be made therein without departing from the spirit and scope of the present invention as defined by the following claims.

For example, in addition to the lead frame 10 according to the above embodiments, the present invention may be applied to another type of semiconductor package frame such as a ball grid array (BGA), and may also be applied to another metal frame for an electronic part, such as a connector.

The present invention may be used in various metal frames for electronic parts, which contact a Sn-based metal material.

## Claims

1. A metal frame for an electronic part, the metal frame comprising a lead unit electrically connected to an electronic device, wherein the lead unit comprises a first metal layer that comprises copper (Cu) as a main component and further comprises boron (B) or beryllium (Be).

2. The metal frame of claim 1, wherein B or Be is from about 0.01 weight% to about 0.5 weight%, and Cu and inevitable impurities are the remaining weight%.

3. The metal frame of claim 1, wherein the first metal layer further comprises iron (Fe).

4. The metal frame of claim 3, wherein Fe is from about 0.1 weight% to about 6 weight%.

5. The metal frame of claim 1, wherein the first metal layer further comprises phosphorus (P).

6. The metal frame of claim 5, wherein P is from about 0.006 weight% to about 0.2 weight%.

7. The metal frame of any one of claims 1 through 6, wherein the first metal layer is integrally formed with at least the lead unit.

8. The metal frame of any one of claims 1 through 6, further comprising a mounting unit on which the electronic device is mounted,
wherein the mounting unit and the lead unit are formed of the same material.

9. The metal frame of any one of claims 1 through 6, further comprising a second metal layer that comprises Sn as a main component, on a surface of the lead unit, to be electrically connected to at least the electronic device.

10. The metal frame of claim 9, wherein the second metal layer is a plating layer formed of pure Sn.
